# EUROPEAN PATENT APPLICATION

(11) **EP 4 693 408 A1**
(43) Date of publication of application: **11.02.2026**
(21) Application number: 24795786.3
(22) Date of filing: 02.04.2024
(51) Int. Cl.: H01L 29/423, H01L 29/10, H01L 29/16, H01L 21/336, H01L 29/78

(54) **TRENCH-TYPE SILICON CARBIDE MOSFET DEVICE AND MANUFACTURING METHOD THEREFOR**

(30) Priority: 25.04.2023 CN 202310450705
(71) Applicant: Nanjing Third Generation Semiconductor Technology Innovation Center Co., Ltd., Nanjing, Jiangsu 211111 (CN); Nanjing Third Generation Semiconductor Technology Innovation Center Co., Ltd., Nanjing, Jiangsu 211111 (CN)
(72) Inventor: ZHANG, Yue, Nanjing, Jiangsu 211111 (CN); ZHANG, Teng, Nanjing, Jiangsu 211111 (CN); BAI, Song, Nanjing, Jiangsu 211111 (CN); HUANG, Runhua, Nanjing, Jiangsu 211111 (CN); YANG, Yong, Nanjing, Jiangsu 211111 (CN)
(74) Representative: J A Kemp LLP
(86) International application number: PCT/CN2024/085630
(87) International publication number: WO 2024/222405

(57) **Abstract**

Provided are a trench-type silicon carbide MOSFET device and a manufacturing method for a trench-type silicon carbide MOSFET device. The method includes that: a first conductivity type epitaxial layer (3) is formed on a first conductivity type substrate (2); part of the first conductivity type epitaxial layer (3) is etched and removed to form a first trench (4); a second conductivity type epitaxial layer (6) is grown, a region of part of the second conductivity type epitaxial layer (6) that is filled in the first trench (4) is defined as a second conductivity type shielding region (6-1), and a region of part of the second conductivity type epitaxial layer (6) that covers the first conductivity type epitaxial layer (3) is defined as a second conductivity type well region (6-2); a first conductivity type source region (9) is formed in the second conductivity type well region (6-2); and a gate trench (7) is formed in the first conductivity type epitaxial layer (3).

## Description

The present application claims priority to Chinese Patent Application No. 202310450705.2, filed with the China National Intellectual Property Administration (CNIPA) on Apr. 25, 2023, the disclosure of which is incorporated herein by reference in its entirety.

### TECHNICAL FIELD

The present application relates to the technical field of semiconductors, for example, to a trench-type silicon carbide MOSFET device and a manufacturing method for a trench-type silicon carbide MOSFET device.

### BACKGROUND

The development of power electronic systems puts forward higher requirements for the performance of semiconductor devices, particularly in terms of high temperature, high frequency, radiation resistance, and high voltage. The traditional manufacturing process of silicon material devices is mature, but the performance of the material itself limits the application of silicon devices in extreme working environments. Silicon carbide (SiC) materials exhibit several superior properties compared to silicon materials, including a larger bandgap width, higher electron saturation drift velocity, stronger radiation resistance, higher breakdown electric field, and higher thermal conductivity. These superior properties enable the SiC materials to hold broad application prospects in fields such as power electronic equipment, aerospace systems, high-speed railway traction devices, and military electronic communication systems.

Compared with a planar-gate SiC metal-oxide-semiconductor field-effect transistor (MOSFET) device, a trench-type SiC MOSFET device forms a channel along a side wall of a trench. This design not only improves channel mobility but also eliminates the junction field effect transistor (JFET) effect, thereby significantly reducing the on-resistance of the device, and enabling a reduction in cell size, which increases power density.

However, the trench-type SiC MOSFET device faces several problems in practical fabrication. First, in the off state, the gate oxide layer at the corner of the trench is required to sustain a relatively high electric field strength, which affects the reliability of the device. Second, the fabrication process flow of the trench-type SiC MOSFET device is relatively complex. Moreover, the structures currently employed to address the aforementioned problems (such as the formation of P-shield layers, superjunction structures, and the like) further increase process complexity, which in turn significantly raises the difficulty of mass production for trench-type SiC MOSFET devices.

### SUMMARY

The present application provides a trench-type silicon carbide MOSFET device and a manufacturing method for a trench-type silicon carbide MOSFET device. A longitudinal conductive channel is formed by forming a gate trench, and a second conductivity type shielding region and a second conductivity type well region are formed by etching and epitaxial regrowth. The depth of the second conductivity type shielding region is significantly greater than the depth of the gate trench, so that the electric field intensity sustained by the gate dielectric inside the gate trench in an off state can be effectively reduced, thereby improving the reliability of the device.

The present application provides a manufacturing method for a trench-type silicon carbide MOSFET device. The method includes the following steps.
a step S1, forming a first conductivity type epitaxial layer on a first conductivity type substrate;
a step S2, etching to remove part of the first conductivity type epitaxial layer to form a first trench;
a step S3, growing a second conductivity type epitaxial layer, defining a region of part of the second conductivity type epitaxial layer that is filled in the first trench as a second conductivity type shielding region, and defining a region of part of the second conductivity type epitaxial layer that covers the first conductivity type epitaxial layer as a second conductivity type well region;
a step S4, forming a first conductivity type source region in the second conductivity type well region;
a step S5, forming a gate trench in the first conductivity type epitaxial layer;
a step S6, forming a gate dielectric layer inside the gate trench;
a step S7, forming a gate electrode on the gate dielectric layer;
a step S8, forming an isolation dielectric layer on the gate electrode;
a step S9, forming a source ohmic contact layer on a surface of the first conductivity type source region and a surface of the second conductivity type well region, and forming a source electrode on a surface of the source ohmic contact layer; and
a step S10, a drain ohmic contact layer under the first conductivity type substrate, and forming a drain electrode on the surface of the drain ohmic contact layer.

In one or more embodiments, the first trench formed in the step S2 has a depth greater than 1.0 µm, an aspect ratio greater than 2:1, an etching angle not less than 80 degrees, and a spacing between adjacent first trenches of not greater than 6.0 µm.

In one or more embodiments, in the step S3, a ratio of the depth of the second conductivity type shielding region to the depth of the first conductivity type epitaxial layer is greater than 1:4, and the second conductivity type shielding region and the first conductivity type epitaxial layer form a superjunction structure or a semi-superjunction structure.

In one or more embodiments, the second conductivity type well region formed in the step S3 has a thickness of not greater than 2.5 µm, and the first trench is completely filled without voids after the step S3 is completed.

In one or more embodiments, the second conductivity type epitaxial layer formed in the step S3 is grown via epitaxial growth, the epitaxial growth is performed with a constant doping concentration or with a variable doping concentration, and the average doping concentration ranges from 1e17cm⁻³ to 1e18cm⁻³.

In one or more embodiments, the gate trench formed in the step S5 is disposed between adjacent first trenches and penetrates through the second conductivity type well region and the first conductivity type source region, and the top of the gate trench is flush with the top of the first conductivity type source region.

In one or more embodiments, after the step S2 and before the step S3, ion implantation is performed on the bottom of the first trench to form a second conductivity type electric field protection region.

In one or more embodiments, after the step S4 and before the step S5, the method further includes high-concentration second-conductivity-type doping implantation to form a second conductivity type heavily doped region in the second conductivity type well region.

The present application further provides a trench-type silicon carbide MOSFET device. The trench-type silicon carbide MOSFET device is completed by the manufacturing method for the trench-type silicon carbide MOSFET device described above. The trench-type silicon carbide MOSFET device includes: a drain electrode; a first conductivity type substrate on the drain electrode; a first conductivity type epitaxial layer on the first conductivity type substrate; a first trench in the first conductivity type epitaxial layer; a second conductivity type epitaxial layer in the first trench and above the first conductivity type epitaxial layer, where a region of part of the second conductivity type epitaxial layer that is filled in the first trench is defined as a second conductivity type shielding region, and a region of part of the second conductivity type epitaxial layer that covers the first conductivity type epitaxial layer is defined as a second conductivity type well region; a first conductivity type source region in the second conductivity type well region; a gate trench in the first conductivity type epitaxial layer; a gate dielectric layer in the gate trench; a gate electrode on the gate dielectric layer; an isolation dielectric layer on the gate electrode; and a source electrode on a surface of the first conductivity type source region and a surface of the second conductivity type well region.

In one or more embodiments, a bottom of the first trench is provided with a second conductivity type electric field protection region.

In one or more embodiments, a second conductivity type heavily doped region is formed in the second conductivity type well region.

### BRIEF DESCRIPTION OF THE DRAWINGS

FIG. 1 is a process flowchart of a manufacturing method for a high-reliability trench-type silicon carbide MOSFET;
FIG. 2 is a flowchart of a manufacturing method for a high-reliability trench-type silicon carbide MOSFET according to an embodiment one;
FIG. 3 is a flowchart of another manufacturing method for a high-reliability trench-type silicon carbide MOSFET according to an embodiment one;
FIG. 4 is a flowchart of another manufacturing method for a high-reliability trench-type silicon carbide MOSFET according to an embodiment one;
FIG. 5 is a flowchart of another manufacturing method for a high-reliability trench-type silicon carbide MOSFET according to an embodiment one;
FIG. 6 is a flowchart of another manufacturing method for a high-reliability trench-type silicon carbide MOSFET according to an embodiment one;
FIG. 7 is a flowchart of another manufacturing method for a high-reliability trench-type silicon carbide MOSFET according to an embodiment one;
FIG. 8 is a flowchart of another manufacturing method for a high-reliability trench-type silicon carbide MOSFET according to an embodiment one;
FIG. 9 is a flowchart of another manufacturing method for a high-reliability trench-type silicon carbide MOSFET according to an embodiment one;
FIG. 10 is a schematic structural diagram of a high-reliability trench-type silicon carbide MOSFET according to an embodiment two;
FIG. 11 is a schematic structural diagram of a high-reliability trench-type silicon carbide MOSFET according to an embodiment three; and
FIG. 12 is a schematic structural diagram of a high-reliability trench-type silicon carbide MOSFET according to an embodiment four.

### List of reference numbers

- 1: drain electrode
- 2: first conductivity type substrate
- 3: first conductivity type epitaxial layer
- 4: first trench
- 5: gate dielectric layer
- 6: second conductivity type epitaxial layer
- 6-1: second conductivity type shielding region
- 6-2: second conductivity type well region
- 7: gate trench
- 8: gate electrode
- 9: first conductivity type source region
- 10: source electrode
- 11: isolation dielectric layer
- 12: second conductivity type electric field protection region
- 13: second conductivity type heavily doped region
- 14: first conductivity type current spreading layer

### DETAILED DESCRIPTION

A high-reliability trench-type silicon carbide MOSFET device and a manufacturing method for a high-reliability trench-type silicon carbide MOSFET device of the present application are described and explained below in conjunction with the drawings and embodiments.

### Embodiment one

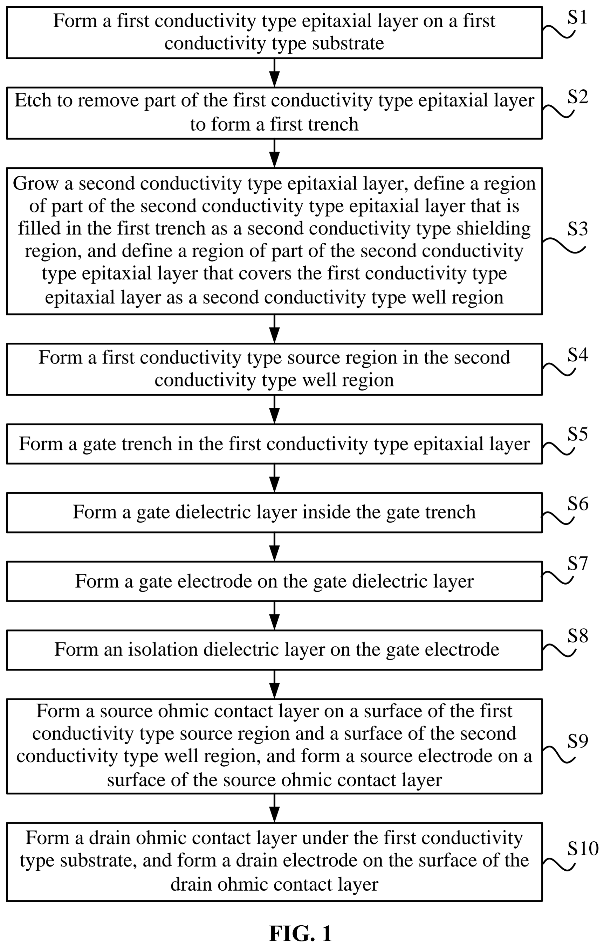

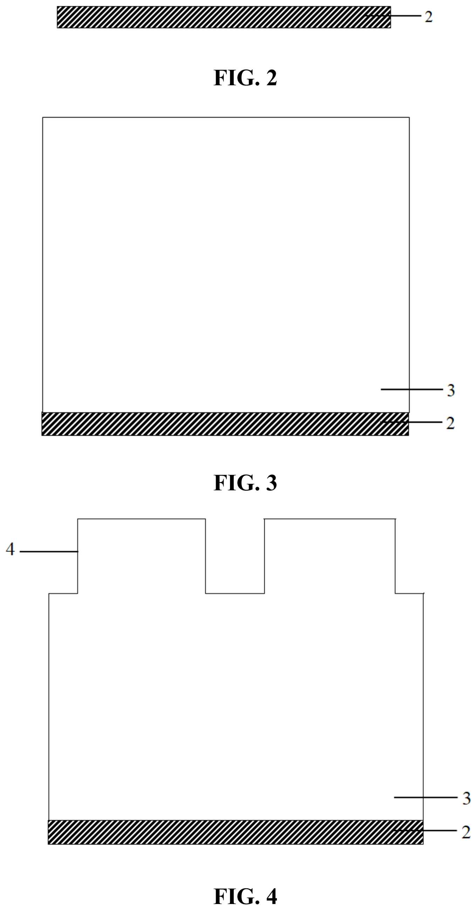

A manufacturing method for a high-reliability trench-type silicon carbide MOSFET device is provided. The flow of the method is shown in FIG. 1, and the method includes the following steps. Hereinafter, each step will be described in conjunction with FIGS. 2 to 9.

In S1, as shown in FIGS. 2 and 3, a first conductivity type epitaxial layer 3 is formed on a first conductivity type substrate 2. The first conductivity type substrate 2 is a first conductivity type silicon carbide substrate. The substrate is made of 3C-SiC, 4H-SiC, 6H-SiC, or 15R-SiC, the thickness of the substrate ranges from 10 µm to 1000 µm, and the doping concentration of the substrate ranges from 1e18cm⁻³ to 5e19cm⁻³. The first conductivity type epitaxial layer 3 is a first conductivity type silicon carbide epitaxial layer. The epitaxial layer is made of 3C-SiC, 4H-SiC, 6H-SiC, or 15R-SiC, the thickness of the epitaxial layer ranges from 8 µm to 200 µm, and the doping concentration of the epitaxial layer ranges from 1e14cm⁻³ to 1e16cm⁻³. In some embodiments of the present application, the first conductivity type epitaxial layer 3 is generated via epitaxial growth.

In S2, as shown in FIG. 4, part of the first conductivity type epitaxial layer 3 is etched and removed to form a first trench 4. The step S2 includes: forming an etching mask layer on a surface of the first conductivity type epitaxial layer 3 by chemical vapor deposition; forming a patterned etching mask layer by a photolithography process; performing inductively coupled plasma etching on the first conductivity type epitaxial layer 3 by using the patterned etching mask layer; and removing the part of the first conductivity type epitaxial layer 3 to form the first trench 4, where the first trench 4 has a width ranging from 0.5 µm to 3.5 µm.

In some other embodiments of the present application, in the step S2, the first trench 4 is formed by a deep trench etching process, the etching process adopts reactive ion etching or inductively coupled plasma etching, and the etching gas is one or a combination of sulfur hexafluoride (SF₆), hydrogen bromide (HBr), chlorine (Cl₂), oxygen (O₂), and argon (Ar).

The first trench 4 formed in the step S2 has a depth greater than 1.0 µm, an aspect ratio greater than 2:1, an etching angle not less than 80 degrees, for example, the angle ranges from 80° to 90°, and a spacing between adjacent first trenches 4 of not greater than 6.0 µm.

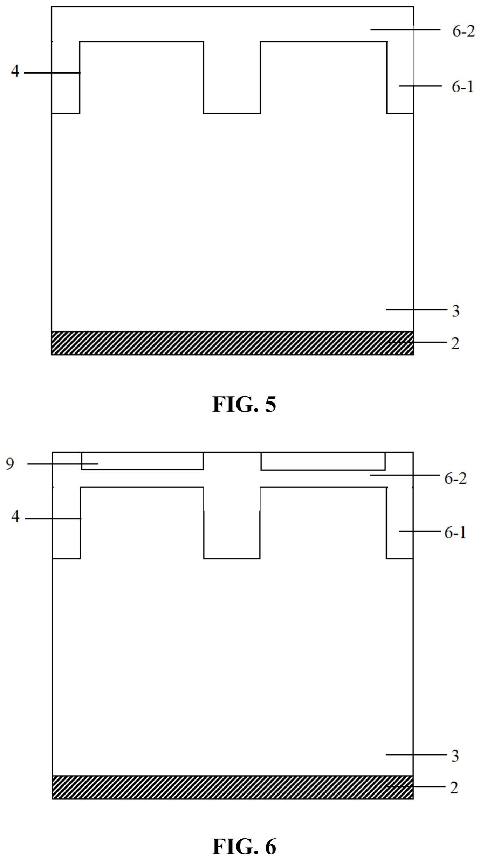

In S3, as shown in FIG. 5, a second conductivity type epitaxial layer 6 is grown, a region of part of the second conductivity type epitaxial layer 6 that is filled in the first trench 4 is defined as a second conductivity type shielding region 6-1, that is, the top of the first trench 4 is flush with the top of the second conductivity type shielding region 6-1, and a region of part of the second conductivity type epitaxial layer 6 that covers the first conductivity type epitaxial layer 3 is defined as a second conductivity type well region 6-2, where the second conductivity type epitaxial layer 6 is a second conductivity type silicon carbide epitaxial layer. The step S3 includes: removing the etching mask layer; and forming the second conductivity type shielding region 6-1 and the second conductivity type well region 6-2 by an epitaxial regrowth process. The second conductivity type epitaxial layer 6 is grown via epitaxial growth, the epitaxial growth is performed with a constant doping concentration or with a variable doping concentration, an average doping concentration ranges from 1e17cm⁻³ to 1e18cm⁻³, and the depth of the second conductivity type shielding region 6-1 is the same as the depth of the first trench 4. The second conductivity type shielding region 6-1 has a depth ranging from 1.5 µm to 7 µm and a width ranging from 0.5 µm to 3.5 µm, and the second conductivity type well region 6-2 has a depth ranging from 0.5 µm to 1.5 µm.

In some other embodiments of the present application, the second conductivity type well region 6-2 formed in the step S3 has a thickness of not greater than 2.5 µm, and the first trench 4 is completely filled without voids after the step S3 is completed. When a ratio of the depth of the second conductivity type shielding region 6-1 to the depth of the first conductivity type epitaxial layer 3 is greater than 1:4, the second conductivity type shielding region 6-1 and the first conductivity type epitaxial layer 3 form a superjunction structure or a semi-superjunction structure. In this case, based on the width relationship between the second conductivity type shielding region 6-1 and the first conductivity type epitaxial layer 3, the doping concentrations of the second conductivity type shielding region 6-1 and the first conductivity type epitaxial layer 3 should satisfy a certain proportional relationship to achieve charge balance in the superjunction structure or the semi-superjunction structure.

In the step S3, the second conductivity type epitaxial layer 6 is grown via epitaxial growth, the epitaxial growth is performed with a constant doping concentration or with a variable doping concentration, and the average doping concentration ranges from 1e17cm⁻³ to 5e18cm⁻³. In the present application, the second conductivity type shielding region 6-1 and the second conductivity type well region 6-2 are formed in a single-step process through the epitaxial regrowth process, which simplifies the process flow. Moreover, the second conductivity type shielding region 6-1 can effectively protect a gate dielectric layer 5, thereby avoiding introducing a technically challenging process of forming an electric field shielding region at the bottom of the gate trench. This significantly reduces process complexity, thereby resulting in a relatively simple manufacturing method that can be applied to achieve mass production of trench-gate-type silicon carbide MOSFET devices with high performance.

In the step S3, after a first epitaxial growth is performed on the second conductivity type shielding region 6-1, a chemical-mechanical planarization (CMP) process is added. In this case, the top of the first trench 4 is flush with the top of the second conductivity type shielding region 6-1. The CMP process is used to planarize the surface of the device, i.e., the SiC surface, then a second epitaxial growth is performed to form the second conductivity type well region 6-2. With the addition of the CMP process, the second conductivity type epitaxial layer 6 is formed through a two-step process. Although this increases process complexity, the CMP process can improve the planarity of the SiC surface, thereby enhancing the quality of subsequent processes.

In S4, as shown in FIG. 6, a first conductivity type source region 9 is formed in the second conductivity type well region 6-2. The step S4 includes: forming an ion implantation mask layer on the surface of the first conductivity type epitaxial layer 3 by chemical vapor deposition; forming a patterned etching mask layer by the photolithography process; performing ion implantation on the first conductivity epitaxial layer 3 by using a patterned ion implantation mask layer to form the first conductivity type source region 9; and annealing at a temperature of 1400°C to 2200°C for 2 min to 30 min after the mask is removed.

In the step S4, the first conductivity type source region 9 is formed in the second conductivity type well region 6-2 and is formed by an ion implantation process. The step of the ion implantation process includes: preparing a patterned mask layer on the surface of the first conductivity type epitaxial layer 3; implanting a first conductivity type impurity; and annealing at a temperature of 1400°C to 2200°C for 2 min to 30 min after removing the mask.

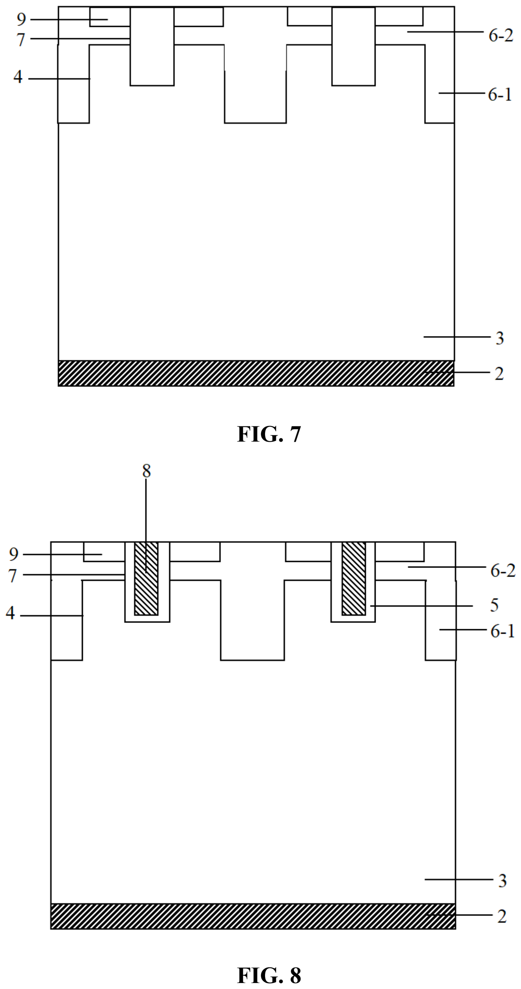

In S5, as shown in FIG. 7, a gate trench 7 is formed in the first conductivity type epitaxial layer 3. The gate trench 7 is disposed between adjacent first trenches 4 and penetrates through the second conductivity type well region 6-2 and the first conductivity type source region 9, and the top of the gate trench 7 is flush with the top of the first conductivity type source region 9. The step S5 includes: forming a patterned etching mask layer on the surface of the first conductivity type epitaxial layer 3; and performing inductively coupled plasma etching by using the patterned etching mask layer to form the gate trench 7.

In some other embodiments of the present application, in the step S5, the gate trench 7 is formed in the first conductivity type epitaxial layer 3 and is formed by an etching process. The etching process adopts reactive ion etching or inductively coupled plasma etching, and the etching gas is one or a combination of SF₆, HBr, Cl₂, O₂, and Ar. After the gate trench 7 is formed, the gate trench 7 is passivated by using a high-temperature annealing process. The gas used in the passivation process is one or a combination of silane (SiH₄), hydrogen (H₂), and Ar, and the annealing temperature ranges from 1400°C to 1800°C.

The depth of the gate trench 7 formed in the step S5 is less than the depth of the first trench 4, and the difference between the depth of the gate trench 7 and the depth of the second conductivity type shielding region 6-1 is not less than 0.5 µm.

The distance between the gate trench 7 formed in the step S5 and the second conductivity type shielding region 6-1 is not more than 2 µm.

In S6, as shown in FIG. 8, a gate dielectric layer 5 is formed inside the gate trench 7. The step S6 includes: forming the gate dielectric layer 5 in the gate trench 7 by an oxidation process and a chemical vapor deposition process, where the gate dielectric layer 5 is made of silicon dioxide (SiO₂), silicon nitride (Si₃N₄) or aluminum oxide (Al₂O₃); and then the quality of the gate dielectric layer 5 is improved by the high-temperature annealing process, where the annealing gas is one or a combination of nitric oxide (NO), nitrous oxide (N₂O), H₂, and ammonia (NH3), and the annealing temperature ranges from 900°C to 1300°C.

In S7, as shown in FIG. 8, a gate electrode 8 is formed on the gate dielectric layer 5. The gate dielectric layer 5 wraps the gate electrode 8, and the top of the gate dielectric layer 5 and the top of the gate electrode 8 are flush with the top of the first conductivity type source region 9. The gate electrode 8 is formed by atomic layer deposition, chemical vapor deposition, and plasma-enhanced chemical vapor deposition or sputtering. The formed gate electrode 8 is made of polycrystalline silicon, non-crystalline silicon, or amorphous silicon, and the doping impurity is aluminum (Al), nitrogen (N), phosphorus (P), or boron (B). When the formed gate electrode 8 is made of polycrystalline silicon, implantation of the polycrystalline silicon is performed, and then the surface of the polycrystalline silicon is planarized by using the CMP process.

In S8, an isolation dielectric layer 11 is formed on the gate electrode 8. The step S8 includes: forming a patterned isolation dielectric layer 11 on the first conductivity type epitaxial layer 3, exemplarily, on the gate electrode 8 through the chemical vapor deposition process and the photolithography process. The bottom surface of the isolation dielectric layer 11 is in contact with the top surfaces of the gate electrode 8, the gate dielectric layer 5, the gate trench 7, and part of the first conductivity type source region 9. In some other embodiments of the present application, the isolation dielectric layer 11 is made of silicon nitride and has a thickness ranging from 0.5µm to 10µm to form a source window. Exemplarily, the isolation dielectric layer 11 is made of silicon dioxide, nitride, or a composite of silicon dioxide and nitride.

In S9, a source ohmic contact layer is formed on a surface of the first conductivity type source region 9 and a surface of the second conductivity type well region 6-2, and a source electrode 10 is formed on a surface of the source ohmic contact layer. The step S9 includes: evaporating, through the source window formed by the isolation dielectric layer 11, metal on the surface of the first conductivity type source region 9 and the surface of the second conductivity type well region 6-2.

In S10, a drain ohmic contact layer is formed under the first conductivity type substrate 2, and a drain electrode 1 is formed on a surface of the drain ohmic contact layer.

In some other embodiments of the present application, the source ohmic contact and the drain ohmic contact, respectively formed in the steps S9 and S10, are created by first forming a metal layer through evaporation, sputtering, or electroplating, followed by annealing at a temperature ranging from 300°C to 1100°C. The metal layer is made of one or a combination of aluminum (Al), titanium (Ti), silver (Ag), nickel (Ni), platinum (Pt), and copper (Cu).

The first conductivity type is N-type or P-type, and the second conductivity type is P-type or N-type.

In the present application, a longitudinal conductive channel is formed by forming the gate trench 7, and the second conductivity type shielding region 6-1 and the second conductivity type well region 6-2 are formed by etching and epitaxial regrowth. The depth of the second conductivity type shielding region 6-1 is significantly greater than the depth of the gate trench 7, so that the electric field intensity sustained by the gate dielectric inside the gate trench 7 in an off state can be effectively reduced, thereby improving the reliability of the device.

In the present application, after the first trench 4 is formed, the second conductivity type well region 6-2 and the second conductivity type shielding region 6-1 are formed in a one-step process through the epitaxial regrowth process. The depth of the second conductivity type shielding region 6-1 is significantly greater than the depth of the gate trench 7, so that the electric field intensity sustained by the gate dielectric inside the gate trench 7 in the off state can be effectively reduced, thereby improving the reliability of the device. In the present application, the process complexity of a trench-gate-type silicon carbide MOSFET device is significantly reduced, resulting in a relatively simple manufacturing method, which can be applied to achieve mass production of high-reliability trench-gate-type silicon carbide MOSFET devices.

A high-reliability trench-type silicon carbide MOSFET device based on the above manufacturing method is provided. The structure of the device includes: a drain electrode 1; a first conductivity type substrate 2 on the drain electrode 1; a first conductivity type epitaxial layer 3 on the first conductivity type substrate 2; a first trench 4 in the first conductivity type epitaxial layer 3; a second conductivity type epitaxial layer 6 in the first trench 4 and above the first conductivity type epitaxial layer 3, where a region of part of the second conductivity type epitaxial layer 6 that is filled in the first trench 4 is defined as a second conductivity type shielding region 6-1, and a region of part of the second conductivity type epitaxial layer 6 that covers the first conductivity type epitaxial layer 3 is defined as a second conductivity type well region 6-2; a first conductivity type source region 9 in the second conductivity type well region 6-2; a gate trench 7 in the first conductivity type epitaxial layer 3; a gate dielectric layer 5 in the gate trench 7; a gate electrode 8 on the gate dielectric layer 5; an isolation dielectric layer 11 on the first conductivity type epitaxial layer 3, where the isolation dielectric layer 11 may be on the gate electrode 8; and a source electrode 10 on a surface of the first conductivity type source region 9 and a surface of the second conductivity type well region 6-2.

### Embodiment two

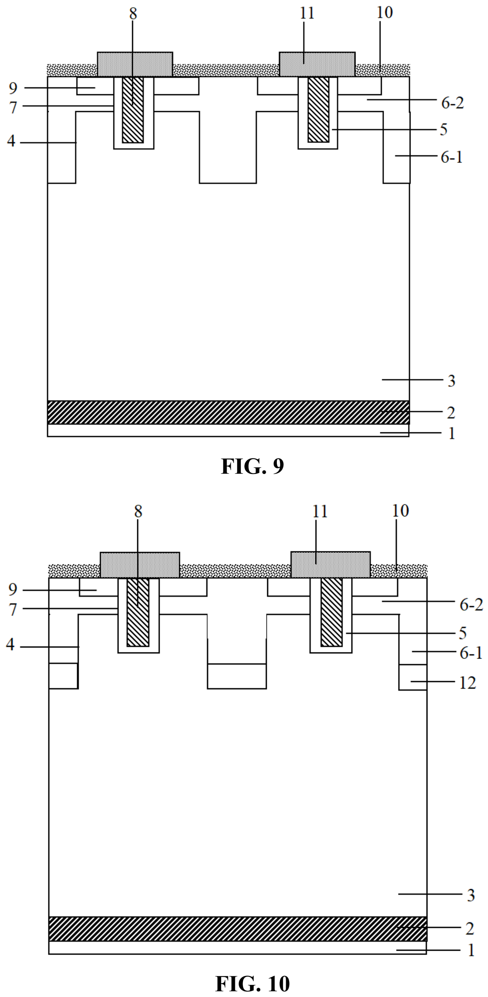

A manufacturing method for a high-reliability trench-type silicon carbide MOSFET is provided. The method in the embodiment three differs from the method in the embodiment one in that: after the first trench 4 is formed through the etching process in the step S2, a patterned ion implantation mask layer is formed on the surface of the first conductivity type epitaxial layer 3, and then ion implantation is performed on the bottom of the first trench 4, that is, a second conductivity type doping implantation is performed on the bottom of the first trench 4 by means of the etching mask layer to form a second conductivity type electric field protection region 12. The second conductivity type electric field protection region 12 has a depth ranging from 0.1 µm to 1 µm and a doping concentration that exhibits a variable doping distribution, where the average doping concentration ranges from 5e17cm⁻³ to 1e19cm⁻³, and the doping concentration of the second conductivity type electric field protection region 12 is significantly higher than those of the second conductivity type shielding region 6-1 and the second conductivity type well region 6-2. After the second conductivity type electric field protection region 12 is formed, the second conductivity type shielding region 6-1 and the second conductivity type well region 6-2 are formed through the epitaxial regrowth process. All other steps are completely the same as those in the embodiment one. The second conductivity type electric field protection region 12 can more effectively protect the gate dielectric layer 5, thereby improving the reliability of the device. A sectional view of the high-reliability trench-type silicon carbide MOSFET formed in this embodiment is shown in FIG. 10. In this embodiment, the bottom of the first trench 4 of the formed high-reliability trench-type silicon carbide MOSFET is provided with the second conductivity type electric field protection region 12.

### Embodiment three

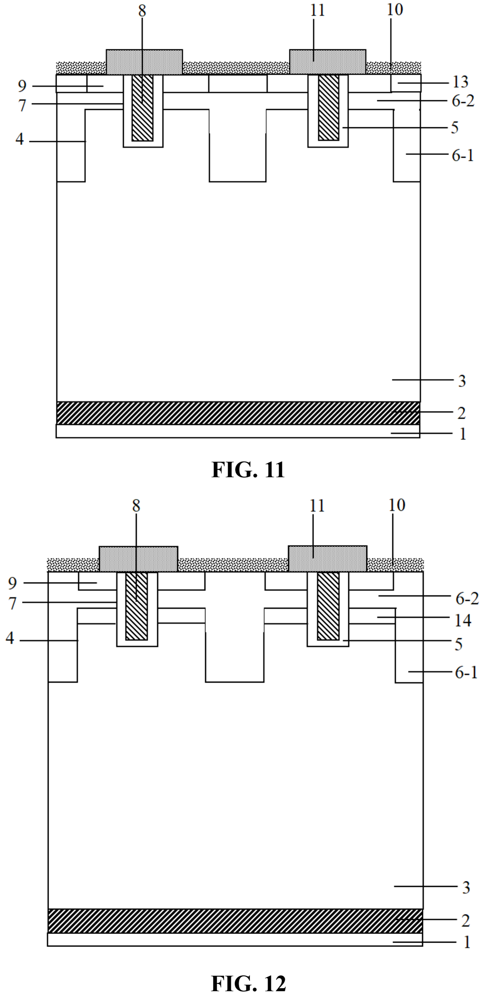

A manufacturing method for a high-reliability trench-type silicon carbide MOSFET is provided. The method in the embodiment three differs from the method in the embodiment one in that: after the first conductivity type source region 9 is formed in the step S4, a patterned ion implantation mask layer is formed on the surface of the first conductivity type epitaxial layer 3, and then a second conductivity type heavily doped region 13 is formed by using the ion implantation process. The second conductivity type heavily doped region 13 has a depth ranging from 0.1 µm to 0.5 µm and a doping concentration that exhibits a variable doping distribution, where the average doping concentration ranges from 5e18cm⁻³ to 5e19cm⁻³. All subsequent steps are completely the same as those in the embodiment one. The second conductivity type heavily doped region 13 can effectively improve the third quadrant characteristics of the device. In this embodiment, after the step S4 and before the step S5, a high-concentration second-conductivity-type doping implantation is added to form a second conductivity type heavily doped region 13 in the second conductivity type well region 6-2. A sectional view of the high-reliability trench-type silicon carbide MOSFET formed in this embodiment is shown in FIG. 11. In this embodiment, the second conductivity type heavily doped region 13 is formed in the second conductivity type well region 6-2 of the formed high-reliability trench-type silicon carbide MOSFET.

### Embodiment four

A manufacturing method for a high-reliability trench-type silicon carbide MOSFET is provided. The method in the embodiment four differs from the method in the embodiment one in that: after the second conductivity type well region 6-2 is formed in the step S3, a patterned ion implantation mask layer is formed on the surface of the first conductivity type epitaxial layer 3, and then a first conductivity type current spreading layer 14 is formed by using the ion implantation process. The first conductivity type current spreading layer 14 has a depth ranging from 0.2 µm to 1.5 µm and a doping concentration that exhibits a variable doping distribution, where the average doping concentration ranges from 1e16cm⁻³ to 1e17cm⁻³. All subsequent steps are completely the same as those in the embodiment one. The first conductivity type current spreading layer 14 can effectively reduce the on-resistance of the device and improve the current density of the device. A sectional view of the high-reliability trench-type silicon carbide MOSFET formed in this embodiment is shown in FIG. 12.

## Claims

1. A manufacturing method for a trench-type silicon carbide MOSFET device, comprising:
forming a first conductivity type epitaxial layer (3) on a first conductivity type substrate (2);
etching to remove part of the first conductivity type epitaxial layer (3) to form a first trench (4);
growing a second conductivity type epitaxial layer (6), defining a region of part of the second conductivity type epitaxial layer (6) that is filled in the first trench (4) as a second conductivity type shielding region (6-1), and defining a region of part of the second conductivity type epitaxial layer (6) that covers the first conductivity type epitaxial layer (3) as a second conductivity type well region (6-2);
forming a first conductivity type source region (9) in the second conductivity type well region (6-2);
forming a gate trench (7) in the first conductivity type epitaxial layer (3);
forming a gate dielectric layer (5) inside the gate trench (7);
forming a gate electrode (8) on the gate dielectric layer (5);
forming an isolation dielectric layer (11) on the gate electrode (8);
forming a source ohmic contact layer on a surface of the first conductivity type source region (9) and a surface of the second conductivity type well region (6-2), and forming a source electrode (10) on a surface of the source ohmic contact layer; and
forming a drain ohmic contact layer under the first conductivity type substrate (2), and forming a drain electrode (1) on a surface of the drain ohmic contact layer.

2. The manufacturing method for the trench-type silicon carbide MOSFET device of claim 1, wherein the first trench (4) formed in the step of etching to remove the part of the first conductivity type epitaxial layer (3) has a depth greater than 1.0 µm, an aspect ratio greater than 2:1, an etching angle not less than 80 degrees, and a spacing between adjacent first trenches (4) of not greater than 6.0 µm.

3. The manufacturing method for the trench-type silicon carbide MOSFET device of claim 1, wherein the second conductivity type well region (6-2) defined as the region of the part of the second conductivity type epitaxial layer (6) that covers the first conductivity type epitaxial layer (3) has a thickness of not greater than 2.5 µm, and the first trench (4) is completely filled without voids after the step of defining the region of part of the second conductivity type epitaxial layer (6) that covers the first conductivity type epitaxial layer (3) as the second conductivity type well region (6-2) is completed.

4. The manufacturing method for the trench-type silicon carbide MOSFET device of claim 1, wherein the second conductivity type epitaxial layer (6) formed in the step of growing the second conductivity type epitaxial layer (6) is grown via epitaxial growth, the epitaxial growth is performed with a constant doping concentration or with a variable doping concentration, and an average doping concentration ranges from 1e17cm⁻³ to 1e18cm⁻³.

5. The manufacturing method for the trench-type silicon carbide MOSFET device of claim 1, wherein the gate trench (7) formed in the step of forming the gate trench (7) in the first conductivity type epitaxial layer (3) is disposed between adjacent first trenches (4) and penetrates through the second conductivity type well region (6-2) and the first conductivity type source region (9), and a top of the gate trench (7) is flush with a top of the first conductivity type source region (9).

6. The manufacturing method for the trench-type silicon carbide MOSFET device of claim 1, wherein after the step of etching to remove the part of the first conductivity type epitaxial layer (3) to form the first trench (4) and before the step of growing the second conductivity type epitaxial layer (6), ion implantation is performed on a bottom of the first trench (4) to form a second conductivity type electric field protection region (12).

7. The manufacturing method for the trench-type silicon carbide MOSFET device of claim 1, after the step of forming the first conductivity type source region (9) in the second conductivity type well region (6-2) and before the step of forming the gate trench (7) in the first conductivity type epitaxial layer (3), the method further comprising high-concentration second-conductivity-type doping implantation to form a second conductivity type heavily doped region (13) in the second conductivity type well region (6-2).

8. A trench-type silicon carbide MOSFET device, completed by the manufacturing method for the trench-type silicon carbide MOSFET device of any one of claims 1 to 7, and comprising:
a drain electrode (1);
a first conductivity type substrate (2) on the drain electrode (1);
a first conductivity type epitaxial layer (3) on the first conductivity type substrate (2);
a first trench (4) in the first conductivity type epitaxial layer (3);
a second conductivity type epitaxial layer (6) in the first trench (4) and above the first conductivity type epitaxial layer (3), wherein a region of part of the second conductivity type epitaxial layer (6) that is filled in the first trench (4) is defined as a second conductivity type shielding region (6-1), and a region of part of the second conductivity type epitaxial layer (6) that covers the first conductivity type epitaxial layer (3) is defined as a second conductivity type well region (6-2);
a first conductivity type source region (9) in the second conductivity type well region (6-2);
a gate trench (7) in the first conductivity type epitaxial layer (3);
a gate dielectric layer (5) in the gate trench (7);
a gate electrode (8) on the gate dielectric layer (5);
an isolation dielectric layer (11) on the gate electrode (8); and
a source electrode (10) on a surface of the first conductivity type source region (9) and a surface of the second conductivity type well region (6-2).

9. The trench-type silicon carbide MOSFET device of claim 8, wherein a bottom of the first trench (4) is provided with a second conductivity type electric field protection region (12).

10. The trench-type silicon carbide MOSFET device of claim 8, wherein a second conductivity type heavily doped region (13) is formed in the second conductivity type well region (6-2).
